# DEMANDE DE BREVET EUROPEEN

(11) **EP 4 486 102 A1**
(43) Date de publication de la demande: **01.01.2025**
(21) Numéro de dépôt: 24182296.4
(22) Date de dépôt: 14.06.2024
(51) Int. Cl.: H10N 97/00

(54) **DISPOSITIF ÉLECTRONIQUE**

(30) Priorité: 27.06.2023 FR 2306700
(71) Demandeur: STMicroelectronics International N.V., 1228 Plan-les-Ouates, Geneva (CH)
(72) Inventeur: BOUFNICHEL, Mohamed, 37380 MONNAIE (FR)
(74) Mandataire: Cabinet Beaumont

(57) **Abrégé**

La présente description concerne un dispositif électronique (10) comprenant au moins deux condensateurs (12) tridimensionnels, chaque condensateur (12) étant entouré par une tranchée (27) comprenant une poche gazeuse (37).

## Description

### Domaine technique

La présente description concerne de façon générale les dispositifs électroniques et leurs procédés de fabrication. Plus précisément, la présente description concerne les dispositifs comprenant des condensateurs tridimensionnels.

### Technique antérieure

Il existe plusieurs types de condensateurs. Un type particulièrement répandu de condensateur correspond aux condensateurs dit MOM, ou Metal-Oxyde-Metal. De tels condensateurs comprennent un empilement de deux couches conductrices, de préférence en métal, séparées par une couche isolante, de préférence en oxyde, par exemple en oxyde de silicium.

Les condensateurs MOM peuvent par exemple être planaires, c'est-à-dire que l'empilement recouvre une couche plane. Les condensateurs MOM peuvent aussi être tridimensionnels, c'est-à-dire recouvrant une couche non plane, par exemple comprenant des cavités. Ainsi, un condensateur tridimensionnel peut avoir une capacitance significativement plus élevée que celle d'un condensateur planaire, pour une même surface de puce.

### Résumé de l'invention

Un mode de réalisation pallie tout ou partie des inconvénients des dispositifs électroniques connus.

Un mode de réalisation prévoit un dispositif électronique comprenant au moins deux condensateurs tridimensionnels, chaque condensateur étant entouré par une tranchée comprenant une poche gazeuse.

Un autre mode de réalisation prévoit un procédé de fabrication d'un dispositif électronique comprenant la formation d'au moins deux condensateurs tridimensionnels, chaque condensateur étant entouré par une tranchée comprenant une poche gazeuse.

Selon un mode de réalisation, les condensateurs et les tranchées sont dans une première couche isolante.

Selon un mode de réalisation, chaque condensateur est situé dans une première région de la première couche, chaque tranchée étant située dans une deuxième région de la première couche séparée de la première région par une troisième région de la première couche.

Selon un mode de réalisation, chaque troisième région n'est pas recouverte de matériau conducteur.

Selon un mode de réalisation, chaque condensateur comprend un premier empilement de deux couches conductrices séparées par une couche isolante, le premier empilement s'étendant de manière conforme sur la première région de la première couche, la première région comprenant au moins deux premières cavités, le premier empilement remplissant les premières cavités.

Selon un mode de réalisation, chaque tranchée comprend un deuxième empilement de couches identiques au premier empilement, s'étendant de manière conforme dans une deuxième cavité, la poche gazeuse étant située dans la deuxième cavité, partiellement délimitée par le deuxième empilement.

Selon un mode de réalisation, le dispositif comprend une deuxième couche fermant chaque deuxième cavité, et délimitant partiellement la poche gazeuse située dans la deuxième cavité.

Selon un mode de réalisation, chaque première région est recouverte d'une troisième couche en le matériau de la deuxième couche.

Selon un mode de réalisation, la deuxième couche s'étend, dans la deuxième cavité, sur moins de 20 % de la hauteur de la deuxième cavité.

Selon un mode de réalisation, chaque poche gazeuse s'étend sur au moins la moitié de la hauteur des premières cavités.

Selon un mode de réalisation, les tranchées entourant au moins deux condensateurs voisins comprennent des portions communes.

Selon un mode de réalisation, les tranchées entourant au moins deux condensateurs voisins sont séparées l'une de l'autre par des portions de la première couche.

Selon un mode de réalisation, le dispositif comprend un filtre, les condensateurs faisant partie du filtre.

Selon un mode de réalisation, le procédé comprend : la formation dans la première couche des premières et deuxièmes cavités ; la formation d'un troisième empilement de deux couches conductrices séparées par une couche isolante de manière conforme, les première cavités étant remplies, les deuxièmes cavités n'étant pas remplies, la formation d'une quatrième couche non conforme fermant les deuxièmes cavités ; la gravure du troisième empilement et de la quatrième couche dans les troisièmes régions de manière à former les premiers et deuxièmes empilement et les deuxièmes et troisièmes couches.

Selon un mode de réalisation, la formation de la quatrième couche est effectuée par un procédé de dépôt physique par phase vapeur ou par un procédé de dépôt chimique en phase vapeur activé par plasma.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A représente une vue en coupe d'un mode de réalisation d'un dispositif comprenant un condensateur tridimensionnel ;
la figure 1B représente une vue de dessus du mode de réalisation de la figure 1A ;
la figure 2A représente une étape d'un procédé de fabrication du dispositif des figures 1A et 1B ;
la figure 2B représente une autre étape d'un procédé de fabrication du dispositif des figures 1A et 1B ;
la figure 2C représente une autre étape d'un procédé de fabrication du dispositif des figures 1A et 1B ;
la figure 3 représente deux vues illustrant deux agencements des condensateurs des figures 1A et 1B.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

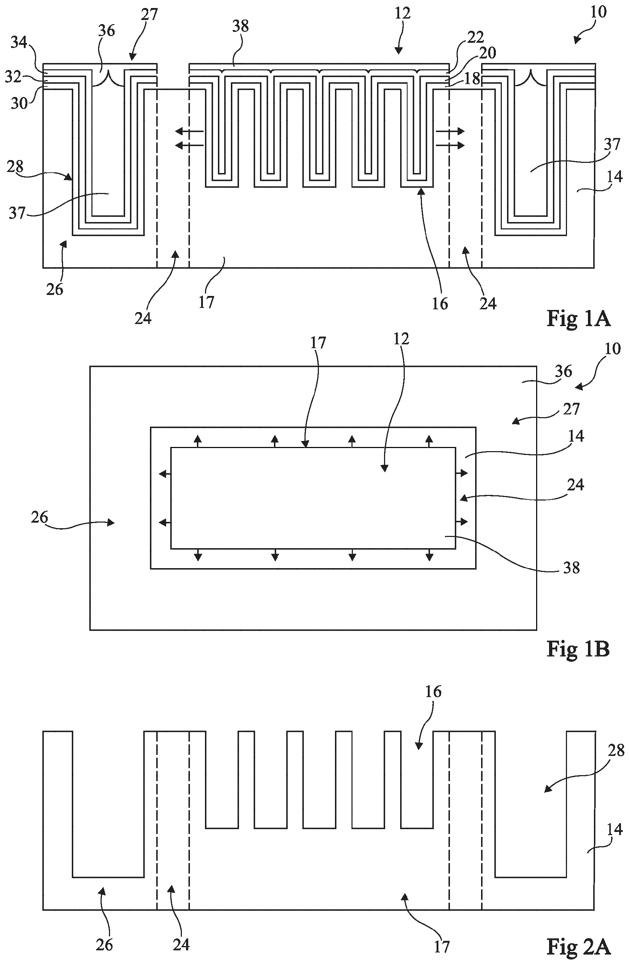

La figure 1A représente une vue en coupe d'un mode de réalisation d'un dispositif 10 comprenant un condensateur tridimensionnel 12. La figure 1B représente une vue de dessus du mode de réalisation de la figure 1A.

Le dispositif 10 comprend une couche isolante 14. La couche 14 est par exemple en un matériau isolant électriquement, par exemple en oxyde de silicium. La couche 14 correspond par exemple à une couche d'un niveau de métallisation d'un réseau d'interconnexion. Ainsi, la couche 14 recouvre par exemple un substrat semiconducteur non représenté. La couche 14 recouvre par exemple une ou plusieurs autres couches isolantes comprenant par exemple chacune des métallisations ou des vias conducteurs.

La couche 14 comprend un ensemble de cavités 16. Les cavités 16 ont par exemple des dimensions identiques les unes aux autres. Chaque cavité 16 s'étend d'une face supérieure de la couche 14 à un niveau interne de la couche 14. Autrement dit, chaque tranchée ne traverse pas la couche 14. Autrement dit, la hauteur des cavités 16 est inférieure à la hauteur de la couche 14.

Les cavités 16 de l'ensemble sont toutes présentes dans une région 17 de la couche 14. Les cavités 16 de l'ensemble sont par exemple agencées en matrice dans la région 17. Chaque ensemble de cavités 16 comprend par exemple au moins deux cavités, par exemple entre 2 et 3000 cavités. Chaque cavité 16 est par exemple séparée de la cavité 16 la plus proche du même ensemble uniquement par une portion de la couche 14.

Le condensateur 12 est formé dans et sur les cavités 16. Le condensateur 12 est par exemple un condensateur de type métal-isolant-métal. Autrement dit, le condensateur 12 comprend une couche conductrice 18, une couche isolante 20 et une couche conductrice 22. Les couches conductrices 18 et22 sont par exemple en métal. La couche 20 est en un matériau diélectrique.

La couche 18, correspondant à une électrode inférieure du condensateur 12, recouvre les parois et le fond des cavités 16 de l'ensemble. La couche 18 recouvre en outre les portions de la face supérieure de la couche 14 situées entre les cavités 16 et recouvre des portions de la face supérieure de la couche 14 autour des cavité 16. Autrement dit, la couche 18 recouvre entièrement la face supérieure de la région 17 de la couche 14 et l'intérieur des cavités 16. La couche 18 recouvre ainsi conformément la région 17 de la couche 14.

La couche 20 s'étend sur la couche 18, par exemple sur l'ensemble de la couche 18. La couche 20 s'étend conformément sur la couche 18. La couche 20 s'étend sur les portions de la couche 18 situées dans les cavités 16 et sur les portions de la couche 18 situées sur la face supérieure de la couche 14.

La couche 22, correspondant à une électrode supérieure du condensateur 12, s'étend sur la couche 20, par exemple sur l'ensemble de la couche 20. La couche 22 s'étend en particulier dans les cavités 16, de préférence sur au moins la moitié de la hauteur des cavités 16. Les dimensions des cavités 16 et des couches 18, 20, 22 sont choisies de telle manière que les cavités 16 soient entièrement remplies par les couches 18, 20, 22.

Les couches 18, 20, 22 s'étendent uniquement dans la région 17. La région 17 est entourée par une région 24 de la couche 14. Les couches 18, 20, 22 ne s'étendent pas sur la face supérieure de la région 24.

La région 24 est de préférence uniquement en le matériau de la couche 14. La région 24 ne comprend de préférence pas de matériau conducteur. La région 24 n'est, de préférence, pas recouverte de matériau conducteur.

La couche 14 comprend en outre une région 26. La région 26 entoure la région 24. La région 26 entoure donc la région 17. La région 26 est séparée de la région 17 par la région 24, de préférence en tout point.

Le dispositif 10 comprend une tranchée 27. La tranchée 27 comprend une cavité 28 située dans la région 26. La cavité 28 forme un anneau. La cavité 28 entoure les régions 17 et 24. Ainsi, la cavité 28 entoure l'ensemble de cavités 16.

Les dimensions de la cavité 28 sont de préférence supérieures aux dimensions d'une des cavités 16. Plus précisément, la hauteur de la cavité 28 est de préférence supérieure à la hauteur d'une des cavités 16. Au moins une des dimensions de l'ouverture de la cavité 28, c'est-à-dire les dimensions de la cavité 28 dans le plan de la face supérieure de la couche 14, est supérieure aux dimensions de l'ouverture d'une des cavités 16. De préférence, toutes les dimensions de l'ouverture de la cavité 28 sont supérieures aux dimensions de l'ouverture d'une cavité 16.

La tranchée 27 comprend un empilement de couches 30, 32, 34 s'étendant de manière conforme dans la région 26. La couche 30 est en le même matériau que la couche 18 et a une épaisseur sensiblement égale à l'épaisseur de la couche 18. Similairement, la couche 32 est en le même matériau que la couche 20 et a une épaisseur sensiblement égale à l'épaisseur de la couche 20. Similairement, la couche 34 est en le même matériau que la couche 22 et a une épaisseur sensiblement égale à l'épaisseur de la couche 22.

La couche 30 recouvre de manière conforme la région 26. Ainsi la couche 30 recouvre les parois latérales et le fond de la cavité 28. La couche 30 recouvre en outre les portions de la face supérieure de la couche 14 situées dans la région 26.

La couche 32 recouvre de manière conforme la couche 30. De préférence, la couche 30 est entièrement recouverte par la couche 32. Ainsi, la couche 32 s'étend dans la cavité 28 et sur la face supérieure de la région 28.

La couche 34 recouvre de manière conforme la couche 32. De préférence, la couche 32 est entièrement recouverte par la couche 34. Ainsi, la couche 34 s'étend dans la cavité 28 et sur la face supérieure de la région 26.

Les couches 30, 32, 34 s'étendent uniquement dans la région 26. Les couches 30, 32, 34 ne s'étendent pas sur la face supérieure de la région 24.

La tranchée 27 comprend en outre une couche 36. La couche 36 s'étend sur les portions de la couche 34 située en dehors de la cavité 28. Ainsi, la couche 36 s'étend en regard de la face supérieure de la région 26. La couche 36 s'étend en outre au niveau de l'ouverture de la cavité 28. La cavité 28 est ainsi fermée par la couche 36. La couche 36 comprend de préférence une première partie s'étendant dans le plan de la face supérieure de la couche 14 et des deuxièmes parties s'étendant dans une partie supérieure de la cavité. De préférence, les deuxièmes parties s'étendent, à partir de l'ouverture de la cavité 28, sur une hauteur inférieure à 20 % de la hauteur de la cavité 28, de préférence inférieure à 10 % de la hauteur de la cavité 28. La couche 36 ne remplit par la cavité 28. Ainsi, une cavité, ou poche, 37 remplie de gaz, par exemple de l'air, est maintenue dans la cavité 28. La poche 37 est délimitée par la couche 34 et la couche 36. La poche 37 s'étend de préférence sur au moins 50 % de la hauteur des cavités 16, de préférence sur au moins 75 % de la hauteur des cavités 16.

Le dispositif 10 comprend en outre une couche 38 en le matériau de la couche 36. La couche 38 recouvre de préférence entièrement la couche 22.

La couche 36 ne s'étend de préférence pas sur la face supérieure de la région 24. De même, la couche 38 ne s'étend de préférence pas sur la face supérieure de la région 24.

Les couches 36 et 38 sont par exemple en un matériau isolant ou en un matériau conducteur, par exemple en un métal.

Le dispositif 10 comprend par exemple des éléments de connexion non représentés permettant de connecter les électrodes supérieure 22 et inférieure 18 du condensateur 12 à un circuit. Les éléments de connexion correspondent par exemple à des vias conducteurs traversant la couche 38 de manière à atteindre la couche 22 ou traversant les couches 20 et 38 au niveau d'une portion de la couche 20 non recouverte par la couche 22, de manière à atteindre la couche 18.

Le remplissage des cavités 16 par des couches de matériaux entraine un stress sur la couche 14. Plus précisément, le remplissage des cavités 16 par des couches de matériaux entraine un stress latéral sur la couche 14, représenté par des flèches dans les figures 1A et 1B. Le remplissage de chaque cavité 16 entraine un stress qui s'ajoute au stress généré par les autres cavités 16. Lors de la formation d'une plaque comprenant uniquement des cavités 16 remplies, le remplissage des cavités 16 peut entraîner un stress suffisamment important pour tordre la plaque et ainsi perturber les étapes de fabrication. Une plaque tordue peut ne pas pouvoir être mise dans une machine effectuant une étape du procédé de fabrication.

Les poches 37 permettent d'absorber le stress généré par les couches 18, 20, 22 dans les cavités 16. Ainsi, les régions 17 et 24 subissent le stress généré par les couches 18, 20, 22 situées dans les cavités 16 de la région 17, mais ne subissent pas le stress généré par d'autres régions 17 situées en dehors de la tranchée 27.

Les tranchées 27 sont de préférence isolées électriquement. Autrement dit, les couches 30, 32, 34 ne sont de préférence reliées à aucun composant électronique et à aucun élément conducteur. Les tranchées 27 ont par exemple pour seule utilité l'absorption du stress généré par les condensateurs 12.

La présence de gaz dans la poche 37 peut entraîner la présence d'éléments indésirables dans la cavité et en contact avec la couche 34. Cependant, les tranchées 27 n'ayant pas de fonction électrique, la formation de défauts sur la couche 34 ne modifie pas l'absorption du stress généré par le condensateur 12.

Les figures 2A à 2C représentent des étapes, de préférence successives, d'un procédé de fabrication du dispositif 10 des figures 1A et 1B.

La figure 2A représente une étape d'un procédé de fabrication du dispositif des figures 1A et 1B.

Au cours de cette étape, la couche 14 est formée. La couche 14 est par exemple formée sur un substrat ou sur un support non représenté. La couche 14 est par exemple une couche plane. Les faces supérieure et inférieure de la couche 14 sont alors parallèles.

L'étape de la figure 2A comprend ensuite la formation des cavités 16 dans la région 17, et la formation de la cavité 28 dans la région 26. La formation des cavités 16 et 28 est de préférence effectuée simultanément, par la même étape de gravure.

La formation des cavités 16 et 28 comprend par exemple la formation d'un masque non représenté sur la face supérieure de la couche 14. Le masque non représenté comprend des ouvertures en regard des emplacements des cavités 16 et 18, lesdites ouvertures ayant des dimensions sensiblement égales aux dimensions des ouvertures des cavités 16 et 18. La formation des cavités comprend ensuite la gravure de la couche 14 à travers les ouvertures du masque. La différence entre les dimensions de l'ouverture des tranchées 16 et les dimensions de l'ouverture de la tranchée 28 entraine la différence de hauteur des cavités formées lors de la gravure.

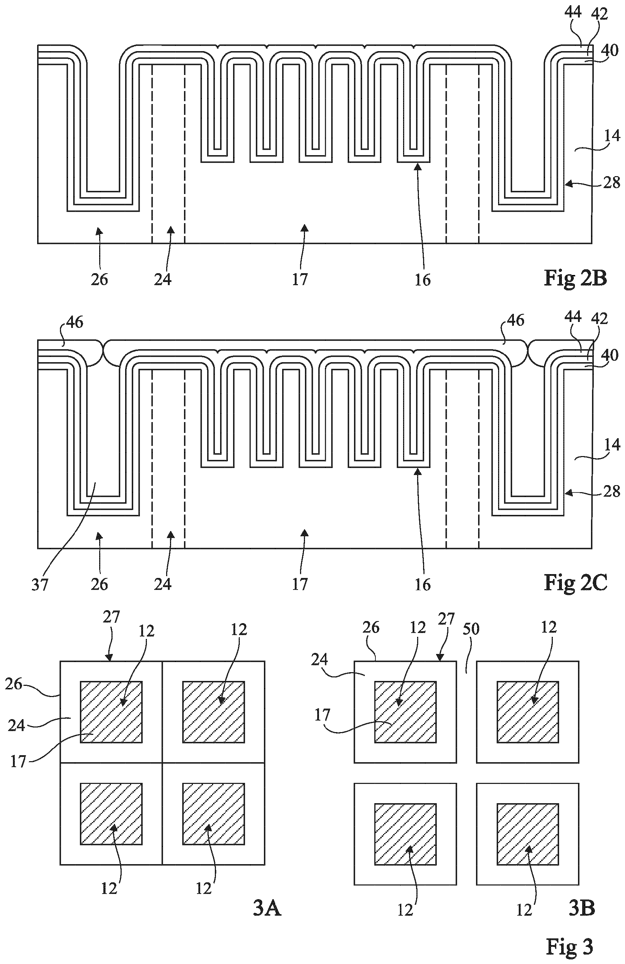

La figure 2B représente une autre étape d'un procédé de fabrication du dispositif des figures 1A et 1B.

Au cours de cette étape, un empilement de couches 40, 42, 44 est formée de manière conforme sur au moins les régions 17, 24 et 26, de préférence sur l'ensemble de la couche 14.

La couche 40 est en le matériau des couches 18 et 30. La couche 40 a une épaisseur sensiblement égale à l'épaisseur des couches 18 et 30. La couche 42 est en le matériau des couches 20 et 32. La couche 42 a une épaisseur sensiblement égale à l'épaisseur des couches 20 et 32. La couche 44 est en le matériau des couches 22 et 34. La couche 44 a une épaisseur sensiblement égale à l'épaisseur des couches 22 et 34.

La couche 40 recouvre, de manière conforme, les régions 17, 24, 28. De préférence, la couche 40 recouvre, de manière conforme, l'ensemble de la couche 14. Ainsi, la couche 40 recouvre les parois latérales et le fond des cavités 16 et 28. La couche 40 recouvre en outre la face supérieure des régions 17, 24, 26 de la couche 14.

La couche 42 recouvre, de manière conforme, la couche 40. De préférence, la couche 42 recouvre entièrement la couche 40. En particulier, la couche 42 recouvre les portions de la couche 40 situées dans les cavités 16 et 28 et sur les faces supérieures des régions 17, 24, 26.

Similairement, la couche 44 recouvre, de manière conforme, la couche 42. De préférence, la couche 44 recouvre entièrement la couche 42. En particulier, la couche 44 recouvre les portions de la couche 42 situées dans les cavités 16 et 28 et sur les faces supérieures des régions 17, 24, 26. La couche 44 a une épaisseur telle que, après la formation de la couche 44, les cavités 16 sont remplies par l'empilement des couches 40, 42, 44. Les épaisseurs de couches 40, 42, 44 sont telles que la cavité 28 ne soit pas remplie par les couches 40, 42, 44. Les dimensions de la cavité 28 et des couches 40, 42, 44 sont telles que, sur au moins la moitié de la hauteur de la cavité 28, les portions de la couche 44 s'étendant sur des parois latérales opposées de la cavité 28 ne sont pas en contact.

La figure 2C représente une autre étape d'un procédé de fabrication du dispositif des figures 1A et 1B.

Au cours de cette étape, une couche non conforme 46 est formée sur la structure résultant de l'étape de la figure 2B. La couche 46 est en le matériau des couches 36 et 38. La couche 46 est formée de manière à fermer la cavité 28, tout en conservant la poche gazeuse 37 dans la cavité 28. La couche 46 est formée par exemple par un procédé de dépôt physique par phase vapeur (PVD - Physical Vapor Déposition), la couche 46 étant par exemple en métal, ou par un procédé de dépôt chimique en phase vapeur activé par plasma (PECVD - Plasma Enhanced Chemical Vapor Déposition), la couche 46 étant par exemple en un diélectrique, par exemple en oxyde de silicium.

Le procédé comprend en outre, après l'étape de la figure 2C, une étape de gravure des portions des couches 40, 42, 44, 46 située sur la région 24. Les couches 18, 20, 22, 30, 32, 34 sont ainsi formées.

Le procédé comprend en outre la formation des éléments de connexion non représentés permettant la connexion des électrodes 18 et 22.

La figure 3 représente deux vues 3A et 3B illustrant deux agencements des condensateurs des figures 1A et 1B. Chaque agencement comprend quatre condensateurs 12. Le dispositif peut cependant comprendre un nombre quelconque de condensateurs 12, par exemple au moins deux condensateurs. Les condensateurs 12 sont par exemple utilisés dans des filtres.

En figure 3, les régions 26, comprenant les tranchées 27 sont représentées par des traits simples, les régions 17 comprenant les condensateurs 12 sont représentées par des rectangles hachurés et les régions 24 séparant les régions 26 et 17 sont représentées par les bandes blanches séparant les rectangles et les traits simples.

Selon le mode de réalisation de la vue 3A, illustrant un premier exemple d'agencement, les tranchées 27 forment un quadrillage, délimitant les régions 24. Dans le mode de réalisation de la vue 3A, les tranchées 27 forment des colonnes et des lignes d'un maillage et délimitent une matrice d'emplacements comprenant chacun une région 17 et une région 24, de préférence une unique région 17 et une unique région 24. Toutes les tranchées 27 sont ainsi reliées les unes aux autres.

Deux condensateurs voisins sont séparés par une unique tranchée 27. Deux condensateurs voisins sont donc séparés par une portion de région 24, une tranchée 27 et une portion d'une autre région 24.

Selon le mode de réalisation de la vue 3B, illustrant un deuxième exemple d'agencement, le dispositif comprend une matrice d'ensembles comprenant une région 17, une région 24 et une région 26, les différents ensembles étant séparés les uns des autres par une portion 50 du substrat 14. Les tranchées 27 sont ainsi indépendantes les unes des autres. Autrement dit, les tranchées 27 sont séparées les unes des autres par les portions 50.

Deux condensateurs voisins sont séparés par deux tranchées 27. Deux condensateurs voisins sont donc séparés par une portion de région 24, une tranchée 27, une portion 50, une tranchée 27 et une portion d'une autre région 24.

Bien que, en figure 3, les condensateurs 12 soient alignées en lignes et en colonnes, les condensateurs peuvent par exemple être alignés en lignes et avoir des colonnes décalées.

De plus, le dispositif comprenant des condensateurs 12 peut comprendre des portions dans lesquelles les condensateurs sont agencés selon le premier agencement et des portions dans lesquelles les condensateurs sont agencés selon le deuxième agencement.

Un avantage des modes de réalisation décrits est qu'il est possible de former des plaques ayant une forte densité de condensateurs tridimensionnels sans causer de déformation.

Un autre avantage des modes de réalisation décrits est que, les tranchées 27 n'étant pas actives électriquement, la présence de la poche gazeuse n'entraine pas de dégâts et n'a pas d'impact sur l'efficacité des condensateurs.

Un autre avantage des modes de réalisation décrits est que la formation simultanée des tranchées 27 et des condensateurs 12 permet d'éviter la déformation de la plaque et permet d'éviter l'ajout d'étapes de formation.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Dispositif électronique (10) comprenant au moins deux condensateurs (12) tridimensionnels, chaque condensateur (12) étant entouré par une tranchée (27) comprenant une poche gazeuse (37).

2. Procédé de fabrication d'un dispositif électronique (10) comprenant la formation d'au moins deux condensateurs (12) tridimensionnels, chaque condensateur (12) étant entouré par une tranchée (27) comprenant une poche gazeuse (37).

3. Dispositif selon la revendication 1 ou procédé selon la revendication 2, dans lequel les condensateurs (12) et les tranchées (27) sont dans une première couche isolante (14).

4. Dispositif ou procédé selon la revendication 3, dans lequel chaque condensateur (12) est situé dans une première région (17) de la première couche (14), chaque tranchée (27) étant située dans une deuxième région (26) de la première couche (14) séparée de la première région (17) par une troisième région (24) de la première couche (14).

5. Dispositif ou procédé selon la revendication 4, dans lequel chaque troisième région (24) n'est pas recouverte de matériau conducteur.

6. Dispositif ou procédé selon la revendication 4 ou 5, dans lequel chaque condensateur (12) comprend un premier empilement (18, 20, 22) de deux couches conductrices séparées par une couche isolante, le premier empilement s'étendant de manière conforme sur la première région de la première couche, la première région comprenant au moins deux premières cavités (16), le premier empilement remplissant les premières cavités (16).

7. Dispositif ou procédé selon la revendication 6, dans lequel chaque tranchée (27) comprend un deuxième empilement (30, 32, 34) des couches identiques au premier empilement (18, 20, 22), s'étendant de manière conforme dans une deuxième cavité (28), la poche gazeuse (37) étant située dans la deuxième cavité (28), partiellement délimitée par le deuxième empilement (30, 32, 34).

8. Dispositif ou procédé selon la revendication 7, dans lequel le dispositif (10) comprend une deuxième couche (36) fermant chaque deuxième cavité (28), et délimitant partiellement la poche gazeuse (37) située dans la deuxième cavité.

9. Dispositif ou procédé selon la revendication 8, dans lequel chaque première région (17) est recouverte d'une troisième couche (38) en le matériau de la deuxième couche (36).

10. Dispositif ou procédé selon la revendication 8 ou 9, dans lequel la deuxième couche (36) s'étend, dans la deuxième cavité (28), sur moins de 20 % de la hauteur de la deuxième cavité.

11. Dispositif ou procédé selon l'une quelconque des revendications 6 à 10, dans lequel chaque poche gazeuse (37) s'étend sur au moins la moitié de la hauteur des premières cavités (16).

12. Dispositif selon l'une quelconque des revendications 1, 3 à 11 ou procédé selon l'une quelconque des revendications 2 à 11, dans lequel les tranchées (27) entourant au moins deux condensateurs (12) voisins comprennent des portions communes.

13. Dispositif selon l'une quelconque des revendications 1, 3 à 11 ou procédé selon l'une quelconque des revendications 2 à 11, dans lequel les tranchées (27) entourant au moins deux condensateurs (12) voisins sont séparées l'une de l'autre par des portions (50) de la première couche.

14. Dispositif selon l'une quelconque des revendications 1, 3 à 13, dans lequel le dispositif comprend un filtre, les condensateurs faisant partie du filtre.

15. Procédé selon l'une quelconque des revendications 7 à 10, le procédé comprenant :
la formation dans la première couche des premières et deuxièmes cavités, ;
la formation d'un troisième empilement de deux couches conductrices séparées par une couche isolante de manière conforme, les première cavités étant remplies, les deuxièmes cavités n'étant pas remplies,
la formation d'une quatrième couche non conforme fermant les deuxièmes cavités ;
la gravure du troisième empilement et de la quatrième couche dans les troisièmes régions de manière à former les premiers et deuxièmes empilement et les deuxièmes et troisièmes couches.

16. Procédé selon la revendication 15, dans lequel la formation de la quatrième couche est effectuée par un procédé de dépôt physique par phase vapeur ou par un procédé de dépôt chimique en phase vapeur activé par plasma.
